(19) **Europäisches Patentamt / European Patent Office / Office européen des brevets**

(11) **EP 2 266 234 B1**

(12) # FASCICULE DE BREVET EUROPEEN

(45) Date de publication et mention de la délivrance du brevet:
**24.07.2013 Bulletin 2013/30**

(21) Numéro de dépôt: **09728233.9**

(22) Date de dépôt: **31.03.2009**

(51) Int Cl.:
*H04L 1/00* (2006.01)   *H04B 7/155* (2006.01)

(86) Numéro de dépôt international:
**PCT/EP2009/053816**

(87) Numéro de publication internationale:
**WO 2009/121883 (08.10.2009 Gazette 2009/41)**

(54) **PROCEDE DE TRANSMISSION D'UN SIGNAL NUMERIQUE ENTRE AU MOINS DEUX EMETTEURS ET AU MOINS UN RECEPTEUR, METTANT EN OEUVRE AU MOINS UN RELAIS, PRODUIT PROGRAMME ET DISPOSITIF RELAIS CORRESPONDANTS**

VERFAHREN ZUM ÜBERTRAGEN EINES DIGITALSIGNALS ZWISCHEN MINDESTENS ZWEI SENDERN UND MINDESTENS EINEM EMPFÄNGER UNTER VERWENDUNG MINDESTENS EINES RELAIS UND ENTSPRECHENDES PROGRAMMPRODUKT UND RELAISEINRICHTUNG

METHOD FOR TRANSMITTING A DIGITAL SIGNAL BETWEEN AT LEAST TWO TRANSMITTERS AND AT LEAST ONE RECEIVER, USING AT LEAST ONE RELAY, AND CORRESPONDING PROGRAM PRODUCT AND RELAY DEVICE

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **02.04.2008 FR 0852190**

(43) Date de publication de la demande:
**29.12.2010 Bulletin 2010/52**

(73) Titulaires:
• **FRANCE TELECOM**
  **75015 Paris (FR)**
• **Institut Mines-Telecom**
  **75634 Paris (FR)**

(72) Inventeurs:
• **PYNDIAH, Ramesh**
  **F-29280 Plouzane (FR)**
• **KABAT, Andrzej**
  **F-29200 Brest (FR)**
• **AMIS, Karine**
  **F-29280 Locmaria Plouzane (FR)**
• **GUILLOUD, Frédéric**
  **F-29280 Plouzane (FR)**

(74) Mandataire: **Bioret, Ludovic**
  **Cabinet Vidon**
  **16 B, rue de Jouanet - B.P. 90333**
  **35703 Rennes Cedex 07 (FR)**

(56) Documents cités:
• **VALENTI M C ET AL: "Distributed turbo codes: towards the capacity of the relay channel" VEHICULAR TECHNOLOGY CONFERENCE, 2003. VTC 2003-FALL. 2003 IEEE 58TH ORLANDO, FL, USA 6-9 OCT. 2003; [IEEE VEHICULAR TECHNOLGY CONFERENCE], PISCATAWAY, NJ, USA,IEEE, US, vol. 1, 6 octobre 2003 (2003-10-06), pages 322-326, XP010700782 ISBN: 978-0-7803-7954-1**
• **LI ET AL: "Distributed Turbo Coding With Soft Information Relaying in Multihop Relay Networks" IEEE JOURNAL ON SELECTED AREAS IN COMMUNICATIONS, IEEE SERVICE CENTER, PISCATAWAY, US, vol. 24, no. 11, 1 novembre 2006 (2006-11-01), pages 2040-2050, XP011142603 ISSN: 0733-8716**
• **HONG WEN ET AL: "Cooperative Coding Using Parallel Concatenated LDPC Codes" INFORMATION THEORY WORKSHOP, 2006. ITW '06 CHENGDU. IEEE, IEEE, PI, 1 octobre 2006 (2006-10-01), pages 395-398, XP031055564 ISBN: 978-1-4244-0067-6**
• **LO E S ET AL: "Cooperative Concatenated Coding for Wireless Systems" COMMUNICATIONS, 2007. ICC '07. IEEE INTERNATIONAL CONFERENCE ON, IEEE, PI, 1 juin 2007 (2007-06-01), pages 6097-6102, XP031126643 ISBN: 978-1-4244-0353-0**

**Description**

**1. domaine de l'invention**

Le domaine de l'invention est celui de la transmission de données codées, d'au moins deux émetteurs vers au moins un récepteur. Plus précisément, l'invention concerne l'amélioration de la qualité de la transmission de telles données, et en particulier des performances du décodage correcteur d'erreurs dans un récepteur.
L'invention s'applique notamment, mais non exclusivement, à la transmission de données via des réseaux sans fil ou mobiles, par exemple pour des applications temps réel.

**2. art antérieur**

Ces réseaux sans fil ou mobiles sont à la recherche de gains significatifs en terme de capacité, de fiabilité, de consommation et autres. Contrairement à un réseau fixe, le canal de transmission d'un réseau sans fil ou mobile est réputé difficile et conduit à une fiabilité de transmission relativement médiocre. Des progrès importants ont été réalisés ces dernières années, en matière de codage et de modulation, notamment pour des considérations de consommation et de capacité. En effet, dans un réseau sans fil où plusieurs émetteurs/récepteurs partagent les mêmes ressources (temps, fréquence et espace) il faut réduire au maximum la puissance d'émission.
Pour fiabiliser les communications on utilise généralement la technique ARQ (« Automatic Request for Repetition », pour « demande automatique de répétition »), qui consiste à retransmettre l'information si le récepteur détecte la présence d'erreurs. Cette technique nécessite des mécanismes de détection d'erreurs et un canal dédié pour la signalisation. Son principal défaut est d'augmenter le délai de transmission et elle est donc peu compatible avec les applications temps réel (téléphonie par exemple). D'autre part, de nouvelles applications émergentes telles que les réseaux de capteurs ou encore la diffusion de signaux TV vers les mobiles ont des contraintes de complexité et/ou de consommation incompatibles avec ces solutions.
Une deuxième approche plus récente consiste à s'appuyer sur des relais pour améliorer l'efficacité de transmission. Le relais peut soit décoder le flux binaire et le retransmettre (« Decode & Forward » en anglais) ou amplifier et retransmettre le signal reçu (« Amplify & Forward » en anglais).
Enfin, il a été proposé de combiner cette technique des relais avec celle dite du « Network Coding » (codage en réseau). Cette approche est par exemple décrite par S. Yang et R. Koetter (« S. Yang and R. Koetter, "Network Coding over a Noisy Relay: a Belief Propagation Approach," in Proc. IEEE ISIT '07, Nice, France, June 2007.). Le relais décode les deux mots de code reçus, émis respectivement par deux sources, puis calcule et transmet le logarithme de rapport de vraisemblance (LLR) de la somme modulo deux bit à bit des deux mots de code. Ainsi, le récepteur dispose de trois observations : les deux sources et le LLR. Cette solution présente plusieurs défauts : elle est très sensible aux erreurs dans le relais, et surtout il faut transmettre la valeur analogique du LLR avec une précision suffisante (4 bits au moins) entre le relais et le récepteur pour chaque bit du flux émis par les sources, ce qui est au détriment de la capacité du réseau. Une approche similaire est proposée par S. Zhang, Y. Zhu, S.-C. Liew, and K. Ben Letaief, (« Joint Design of Network Coding and Channel Decoding for Wireless Networks » in Proc. IEEE WCNC '07, pp. 779-784, 11-15 March 2007). Toutefois, les auteurs ont étudié la réduction de complexité dans le relais sans aborder le décodage dans le récepteur.
Une autre approche décrite dans "Distributed turbo codes: towards the capacity of the relay channel" par M. Valenti et B. Zhao, VTC IEEE, oct. 2003, présente une technique de turbo codes distribués utilisant un émetteur source, un relais et un récepteur.
Dans ces différents cas, le décodage reste peu aisé, et il n'y a pas de solution simple et efficace pour le traitement dans les récepteurs.

**3.** Caractéristiques **principales** de l'invention

L'invention propose un procédé de transmission d'un signal numérique entre au moins deux émetteurs et au moins un récepteur, mettant en oeuvre une concaténation d'au moins deux codes, comprenant :

- une première étape de codage, dans lesdits émetteurs, chacun délivrant au moins un premier mot de code ;
- une première étape d'émission desdits premiers mots de code ;
- une étape de réception, dans au moins un dispositif relais, d'au moins deux desdits premiers mots de code, appelés mots de code intermédiaires ;
- une étape d'entrelacement d'au moins une partie des bits desdits mots de code intermédiaires délivrant des bits entrelacés ;
- une seconde étape de codage desdits bits entrelacés, dans le ou lesdits relais, délivrant au moins un second mot de code tenant compte desdits mots de code intermédiaires;

- une seconde étape d'émission du ou desdits seconds mots de code par le ou lesdits dispositifs relais,

de façon à permettre, dans le ou lesdits récepteurs, un décodage itératif tenant compte desdits premiers mots de code puis d'une redondance formée par le ou lesdits seconds mots de code.

La première étape d'émission peut notamment être mise en oeuvre via au moins deux canaux de transmission distincts, de façon à augmenter la diversité. Ces canaux peuvent être distincts par exemple du fait que les émetteurs sont distincts, qu'un desdits au moins deux émetteurs met en oeuvre plusieurs antennes d'émission, que le relais met en oeuvre plusieurs antennes de réception, ou encore que lesdits au moins deux émetteurs et/ou le relais comprennent des moyens pour faire varier le canal de transmission au cours du temps (par exemple des moyens d'application d'un retard variable).

Ainsi, l'invention repose en particulier sur l'introduction d'un entrelacement et d'un codage dans le ou les dispositifs relais, ce qui permet de faire bénéficier à l'ensemble des émetteurs dispersés du gain de codage d'un turbo-code. Le codage peut notamment être une combinaison bit à bit d'au moins deux des mots de code intermédiaires reçus par le relais. En effet, l'approche de l'invention permet de mettre en oeuvre, dans les récepteurs, un décodage itératif, s'appuyant sur une redondance générée dans les relais, sans nécessiter la mise en oeuvre du turbo-codage dans les émetteurs.

Cette approche permet par ailleurs de réduire les délais de codage, par rapport à un turbo-codage classique, qui serait mis en oeuvre dans chaque émetteur, et qui serait incompatible avec des applications temps réel, tout en simplifiant le traitement et la complexité de ces émetteurs.

En d'autres termes, l'invention repose sur une approche nouvelle, proposant une distribution en réseau du codage correcteur d'erreurs, ou du turbo-codage.

De nombreuses variantes de mises en oeuvre peuvent être envisagées, selon le type d'entrelacement, le type de codage, le nombre d'émetteurs et de relais (qui peuvent être cascadés), la concaténation des codes (parallèle, série, ou quelconque).

Selon un premier mode de réalisation, ladite étape d'entrelacement met en oeuvre un entrelacement pseudo-aléatoire.

Selon un deuxième mode de réalisation, cette étape d'entrelacement met en oeuvre une matrice lignes/colonnes d'un code produit.

Dans ce cas, lesdits premiers mots de code peuvent comprendre des bits d'information et des bits de redondance de ligne et lesdits seconds mots de code forment des mots de code de redondance à partir de bits de redondance de colonne, permettant la construction d'une matrice de code produit dans le ou lesdits récepteurs.

On dispose alors, dans le récepteur, d'un code produit, qui peut être décodé de façon itérative, par exemple à l'aide de l'algorithme Chase-Pyndiah pour les codes en blocs ou de tout autre méthode adaptée de décodage pour le code considéré.

Lesdites première et seconde étapes d'émission peuvent mettre en oeuvre une technique d'accès multiple suivant une répartition en temps (TDMA), en fréquence (FDMA) et/ou par codes de modulation (CDMA), ou tout autre technique d'accès multiple, permettant de séparer les différentes contributions dans les récepteurs.

Selon une première approche, ladite étape de réception dans le relais met en oeuvre une décision dure sur la valeur de chacun des bits reçus dans le relais pour former lesdits mots de code intermédiaires.

Cette approche est simple et rapide à mettre en oeuvre.

Selon une deuxième approche, ladite étape de réception dans un desdits dispositifs relais met en oeuvre une sous-étape de seuillage sur la valeur de chacun des bits reçus dans ledit dispositif relais, délivrant des données seuillées, et une sous-étape de correction d'erreurs desdites données seuillées, pour former lesdits mots de code intermédiaires.

Selon une troisième approche, ladite étape de réception dans un desdits dispositif relais est suivi d'une étape de décodage souple sur la valeur souple de chacun des bits reçus dans ledit relais, pour former lesdits mots de code intermédiaires.

Dans ce cas, ladite étape de décodage souple peut notamment mettre en oeuvre une étape de recherche d'un mot de code qui minimise l'erreur quadratique par rapport aux valeurs souples reçues.

Ceci permet d'obtenir une efficacité supérieure à la première approche, car elle réduit le nombre d'erreurs dans le relais.

Dans au moins un mode de réalisation de l'invention, le procédé comprend également une étape d'affectation dans le relais, à au moins un desdits bits desdits seconds mots de code, d'une information de fiabilité.

Il est ainsi possible d'améliorer encore la qualité du décodage, en introduisant une pondération.

Ladite information de fiabilité peut notamment comprendre au moins un bit de signalisation indiquant la position d'au moins un bit de faible fiabilité dans ledit second mot de code.

Comme déjà mentionnés, l'invention peut être mise en oeuvre avec de nombreux types de codes. Ladite première étape de codage et/ou ladite seconde étape de codage peuvent par exemple mettre en oeuvre un codage linéaire appartenant au groupe comprenant :

- les codes convolutifs ;
- les codes BCH ;
- les codes RS ;
- les turbo-codes ;
- les codes LDPC binaires ou non-binaires ;
- les codes de parité.

Dans au moins un mode de réalisation particulier, au moins un premier dispositif relais reçoit au moins un mot de code intermédiaire émis par un second dispositif relais.

En d'autres termes, il est possible de cascader des dispositifs relais. Plus généralement, de nombreux arrangements, le cas échéant variables dans le temps et/ou l'espace, sont envisageables pour combiner les émetteurs et les relais de façon à améliorer la qualité du décodage.

L'invention concerne également un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé de transmission décrit ci-dessus.

L'invention concerne encore les dispositifs relais pour la mise en oeuvre de ce procédé. Un tel dispositif relais comprend notamment :

- des moyens de réception d'au moins deux mots de code intermédiaires émis par au moins deux dispositifs émetteurs et/ou au moins un autre dispositif relais ;
- des moyens d'entrelacement d'au moins une partie des bits desdits mots de code intermédiaires délivrant des bits entrelacés ;
- des moyens de codage desdits bits entrelacés, de façon à former au moins un second mot de code tenant compte desdits mots de code intermédiaires ;
- des moyens d'émission du ou desdits seconds mots de code.

### 5. liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 est un premier exemple de système de transmission mettant en oeuvre le procédé de l'invention ;
- la figure 2 est un organigramme simplifié du procédé de transmission mis en oeuvre dans le système de la figure 1 ;
- la figure 3 illustre un code produit obtenu par l'invention, dans un mode de réalisation particulier ;
- la figure 4 décrit les moyens principaux présents dans un dispositif relais selon l'invention ;
- la figure 5 présente un deuxième exemple de système selon l'invention, à quatre émetteurs, un relais et un récepteur ;
- les figures 6A à 6D illustrent les performances obtenues avec le système de la figure 5 ;
- la figure 7 présente un troisième exemple de système selon l'invention, à trois émetteurs, deux relais et un récepteur ;
- la figure 8 illustre les taux d'erreur par rapport au rapport signal à bruit obtenu avec le système de la figure 7, avec différents types de codage ;
- la figure 9 présente un quatrième exemple de système selon l'invention, dans un réseau ad-hoc.

### 6. description de modes de réalisation particuliers

*6.1 généralités*

L'invention propose donc une nouvelle approche de l'utilisation de dispositifs relais (ou relais), pour améliorer la qualité de la transmission, tout en permettant un décodage simple et efficace dans les récepteurs.

Pour cela, le ou les relais reçoivent les mots de code (ou au moins certains d'entre eux) produits par les émetteurs (ou au moins certains d'entre eux), et produisent au moins un mot de code supplémentaire en fonction des mots de code reçus. Ces mots de code supplémentaires sont transmis vers le récepteur (ou les récepteurs), qui traite l'ensemble des mots de code reçus, des émetteurs et du ou des relais, comme un tout, selon un décodage itératif dont l'approche est connue en soi.

Selon différents modes de réalisation, il peut n'y avoir qu'un ou plusieurs émetteurs, avec une ou plusieurs antennes d'émission. Dans la plupart des cas, le ou les relais (et le ou les récepteurs) peuvent donc recevoir des mots de code transmis via des canaux de transmission distincts.

Chaque dispositif relais fournit donc des mots de code de redondance, qui permettent d'améliorer le décodage.

Ces mots de code de redondance sont formés en appliquant un entrelacement aux mots de code reçus, et un codage des bits entrelacés. Dans une approche intéressante de l'invention, l'entrelacement est obtenu en plaçant les mots de code reçus dans les lignes d'une matrice, et en codant les colonnes de cette matrice. Les bits de redondance de colonnes peuvent alors former des mots de code supplémentaires, qui seront décodés dans les récepteurs comme un code produit classique.

Selon cette approche, on réalise, vu du récepteur, une concaténation série de codes. Il est également possible de réaliser une concaténation parallèle, en ne traitant pas les colonnes correspondant à des bits de redondance.

Il est également possible d'appliquer un entrelacement quelconque, par exemple pseudo-aléatoire, et le cas échéant variable dans le temps (une signalisation devant alors être prévue pour informer le récepteur de l'entrelacement mis en oeuvre).

Les bits reçus sont décodés (avant ou après entrelacement) par seuillage ou de façon « dure » ou de façon « souple », avant de subir un nouveau codage. Le décodage souple peut par exemple mettre en oeuvre une recherche du mot de code qui minimise l'erreur quadratique par rapport aux valeurs reçues. Dans ce cas, il est possible d'associer aux données codées une information de confiance, ou de fiabilité. Il peut notamment s'agir d'un bit de signalisation indiquant la position d'au moins un bit de faible fiabilité dans un des seconds mots de code.

De nombreux types de codes peuvent être utilisés dans les émetteurs et dans les relais, dès lors qu'il s'agit de codes linéaires. Il peut notamment s'agir de :

- codes convolutifs ;
- codes BCH ;
- codes RS ;
- turbo-codes ;
- codes LDPC binaires ou non-binaires ;
- codes de parité.

Il est possible d'utiliser le même code dans ces émetteurs et les relais, ou des codes différents.

Une méthode d'accès multiple est utilisée, pour permettre au récepteur de recevoir indépendamment les différents mots de code. Dans la suite, on considère la mise en oeuvre d'une répartition en temps (TDMA). Cependant, un répartition en fréquence (FDMA) ou par codes de modulation (CDMA), et le cas échéant leurs combinaisons, sont possibles.

*6.2 premier monde de réalisation*

*6.2.1 principe*

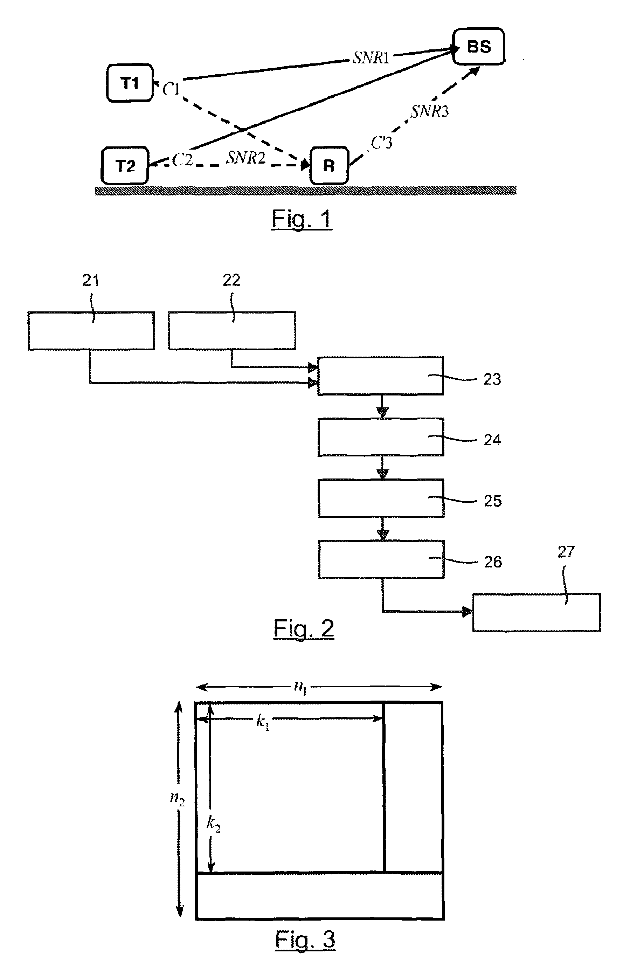

Dans le cas d'un système de transmission simple, illustré par la figure 1, mettant en oeuvre deux émetteurs T1, T2, un relais R et un récepteur BS (dans l'exemple de mise en oeuvre, une station de base), le relais reçoit C1 et C2 et délivre la séquence C'3.

La station de base dispose donc de trois mots de code, ou séquences, C1, C2 et C'3, qu'elle peut décoder selon une méthode de décodage itératif.

Le procédé mis en oeuvre est illustré de façon simplifiée en figure 2.

Chaque émetteur envoie (21, 22) un mot de code C1, C2. Selon les modes de réalisation, on peut bien sûr prévoir que les émetteurs envoient plusieurs mots de code simultanément, le cas échéant à des débits différents et/ou de façon variable dans le temps. A nouveau, dans ce cas, une signalisation adaptée est préférentiellement mise en oeuvre.

Le relais reçoit (23) ces mots de code, et applique un seuillage bit à bit des observations pour donner C'1 et C'2. On peut noter que C'1 et C'2 ne sont pas obligatoirement les mots de code initiaux, à cause des erreurs éventuellement.

Ces mots de codes intermédiaires sont entrelacés (24), et les données entrelacées sont codées (25) pour fournir C'3. Comme indiqué précédemment, l'entrelacement 24 peut notamment consister en une écriture dans les lignes d'une matrice, et le codage 25 être appliqué sur les colonnes de la matrice.

On obtient alors un code produit, tel qu'illustré en figure 3 sous une forme généralisée à n1 colonnes et n2 lignes. Elle comprend k2 lignes correspondant chacune à un mot de code reçu des émetteurs, et comprenant chacune k1 bits d'information et n1-k1 bits de redondance, ou de parité, de ligne.

Les n2-k2 lignes restantes sont des mots de code de redondance, construits dans le relais, et correspondant à des bits de parité de colonne.

Il est à noter que, dans ce mode de réalisation de construction d'un code produit, le codage 25 peut correspondre à une somme modulo 2 bit à bit de C'1 et C'2 pour former C'3.

Le relais transmet ensuite (26) vers la station de base BS la séquence binaire C'3.

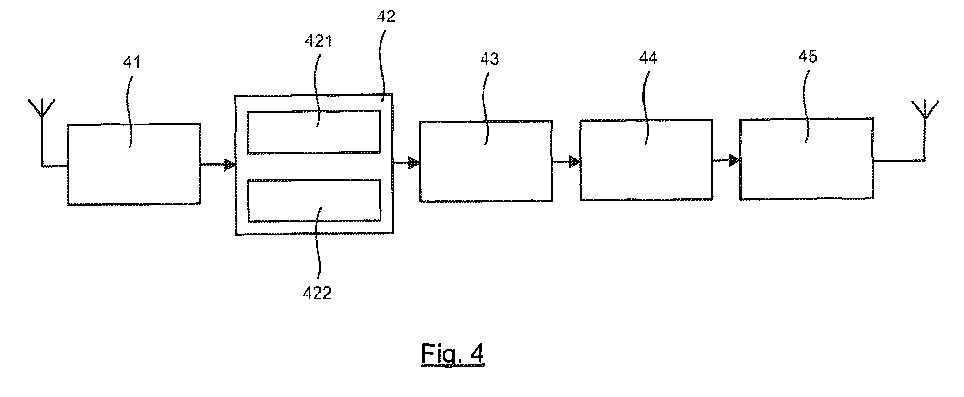

La structure d'un mode de réalisation d'un tel relais est illustrée en figure 4. Il comprend des moyens 41 de réception des mots de code émis par les émetteurs, et des moyens 42 de décodage de ces mots de code, pour restituer des bits décodés. Les moyens de décodage comprennent des moyens 421 de décision dure, par seuillage, et le cas échéant des moyens 422 de décision souple, associant une valeur de confiance à la décision dure.

Une approche intermédiaire peut consister à réaliser une correction d'erreurs sur des données seuillées (« hard decoding » en anglais) dans le relais, pour former lesdits mots de code intermédiaires. Si le codage dans le relais s'effectue au-dessus de la couche physique, on ne dispose pas de décision souple, mais on peut améliorer les performances par rapport au seuillage en effectuant un décodage dur.

Les bits décodés sont ensuite entrelacés, par exemple ligne par ligne dans une matrice 43, lues colonne par colonne. Un ou plusieurs mots de code de redondance sont déterminés, par des moyens de codage 44 associant à chaque colonne un ou plusieurs bits de parité.

Les mots de code de redondance ainsi formés sont ensuite émis (45) vers le récepteur.

Cette station de base BS reçoit donc les observations de C1, C2 et C'3. Il doit décoder C1, C2 à partir des observations de C1, C2 et C'3.

On peut observer que C1, C2 et C'3 forment un code produit, que l'on peut décoder (27) par un turbo décodage, comme détaillé ci-après.

*6.2.2 turbo décodage*

Les turbo-codes, présentés par C. Berrou et A. Glavieux notamment dans le document "Near Shannon limit error-correcting coding and decoding : Turbo-codes (1)," IEEE Int. Conf. on Comm. ICC' 93, pp. 1064- 1071, vol 2/3, May 1993, reposent sur la mise en oeuvre de deux codes convolutionnels systématiques récursifs concaténés en parallèle, par l'intermédiaire d'un entrelacement non uniforme. Le décodage est par exemple un décodage itératif à entrées souples et sorties souples (SISO « soft input soft output » en anglais), utilisant des informations extrinsèques.

R. Pyndiah a montré que les turbo-codes peuvent être adaptés aux codes en blocs. Cette approche consiste à concaténer deux codes en blocs en série par l'intermédiaire d'un entrelacement uniforme lignes / colonnes. Cette technique est connue sous le nom de codes produits (voir P. Elias, "Error-free coding," IRE Trans. on Inf. Theory, pp. 29-37, vol. IT-4, Septembre 1954). Le décodage peut également mettre en oeuvre un décodage itératif à entrées souples et sorties souples (SISO), utilisant par exemple l'algorithme Chase-Pyndiah décrit dans "Near optimum decoding of product codes : block turbo codes" (IEEE, Trans. on Communications, Vol. 46, n° 8, Août 1998).

On rappelle que la mise en oeuvre d'un code produit peut se représenter sous la forme d'une matrice de n1 lignes et n2 colonnes, telle qu'illustrée par la figure 3. Le code produit est alors obtenu par :

- le codage des bits d'information des k2 premières lignes, à l'aide d'un code de lignes de paramètres $(n1, k1, \delta1)$ ;
- le codage des n1 colonnes, à l'aide d'un code de colonnes de paramètres $(n2, k2, \delta2)$.

Les n2 lignes, respectivement les n1 colonnes, forment des mots de code d'un code C1, respectivement C2. Les paramètres du code produit correspondant sont $(N=n1 *n2, K=k1*k2, \Delta=\delta1*\delta2)$. Un tel code présente une distance minimum très élevée. Ces codes peuvent être tout code en blocs linéaires systématiques, tels que des codes BCH (comme proposé dans l'article "Near optimum decoding of product codes : block turbo codes" précité), et plus généralement toute combinaison de codes linéaires, tels que des codes convolutionnels, des codes de Golay, des codes de parité,...

Les lignes et les colonnes sont successivement décodées, à l'aide de l'algorithme Chase-Pyndiah.

Dans le cas du mode de réalisation de la figure 1, on considère que les deux terminaux T1 et T2 utilisent le même code $(n, k, \delta)$, et que les mots de code sont transmis à l'aide d'une modulation BSPK (« Binary Phase-Shift Keying », soit modulation binaire par décalage de phase) dans un canal AWGN (« Additive White Gaussian Noise », pour bruit blanc additif gaussien).

Le terminal T1 transmet le mot de code C1, et le terminal T2 transmet le mot de code C2. Le relais R reçoit les signaux correspondants, et délivre les estimations C' 1 et C'2. Cette estimation est par exemple obtenue par un seuillage sur le logarithme de rapport de vraisemblance (LLR) en sortie d'un démodulateur, dans le cas de décisions dures. Il est également possible de mettre en oeuvre un décodage souple correcteur d'erreur des valeurs LLR de chaque mot de code.

Le relais R effectue ensuite une combinaison bit à bit de C' 1 et C'2, pour fournir le mot de code C'3 qui est transmis vers la station de base BS, qui assure la fonction de récepteur au sens des revendications.

On peut écrire :

$$C'1 = C1 \oplus E1$$

$$C'2 = C2 \oplus E2$$

avec E1 et E2 les erreurs introduites lors de l'estimation de C1 et C2 dans le relais.

C'3 peut alors s'écrire :

$$C'3 = C'1 \oplus C'2 = C1 \oplus E1 \oplus C2 \oplus E2 = C3 \oplus E$$

où C3 est un mot de code obtenu par combinaison linéaire de C1 et C2 et E une erreur correspondant à la combinaison linéaire de E1 et E2.

La station de base BS reçoit donc trois signaux, correspondant respectivement à C1, C2 et C'3. Dans cette station de base, selon l'invention, ces signaux vont être décodés comme un code produit. Les séquences C1, C2 et C'3 sont donc placées dans une matrice 3*n, pour former respectivement les trois lignes de celles-ci :

$$C1 = (c_1^1, c_2^1, ..., c_n^1)$$

$$C2 = (c_1^2, c_2^2, ..., c_n^2)$$

$$C'3 = (c_1^3, c_2^3, ..., c_n^3)$$

Cette matrice est un code produit, si l'erreur E est nulle, c'est-à-dire si aucune erreur n'a été introduite par le relais.

Dans le cas où l'erreur E est non nulle, l'un desdits au moins deux émetteurs va émettre des mots de code avec des erreurs. La matrice reçue peut être considérée comme un mot de code produit comprenant des erreurs introduites par la transmission (d'un desdits au moins deux émetteurs vers un relais et/ou d'un relais vers la station de base) auxquelles s'ajoutent celles éventuellement introduites dans le relais.

Dans ce dernier cas, la fiabilité sur les bits provenant du relais n'est pas fiable (bit faux avec une fiabilité forte) et dégrade les performance du décodeur. Le turbo code en blocs présente un avantage important, dans cette situation, car il est beaucoup plus robuste que les schémas précédents (tels que les codes convolutifs RSC avec concaténation parallèle). En effet, un code RSC génère une longue suite d'erreurs pour une erreur isolée en entrée, contrairement aux codes en blocs. D'autre part, avec la concaténation parallèle, les bits de redondance ne bénéficient pas de l'information extrinsèque contrairement aux codes produits. Lors du décodage itératif, les erreurs générées dans le relais peuvent être corrigées, ce qui limite la dégradation induite.

Les lignes de cette matrice sont des mots de code d'un code en blocs (n, k, $\delta$) et les colonnes sont des mots de code d'un code de parité (3, 2, 2). Ce code produit peut donc être décodé de façon itérative, selon l'algorithme Chase-Pyndiah, ou tout autre méthode appropriée.

On constate que cette approche selon l'invention permet d'obtenir, dans un réseau sans fil à codage de canal distribué, des performances similaires à un turbo code.

*6.3 deuxième mode de réalisation*

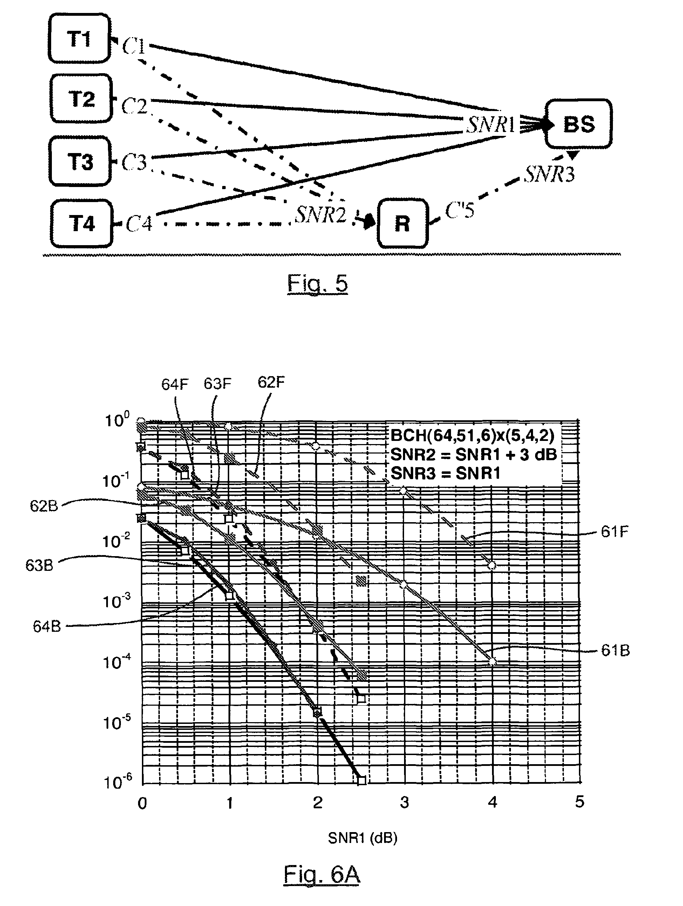

La figure 5 illustre un exemple de mise en oeuvre de l'invention avec quatre émetteurs, un relais et un récepteur. Les figures 6A à 6D présentent les résultats de simulation obtenus pour un tel système.

On considère donc le cas où quatre terminaux T1, T2, T3 et T4 émettent vers une station de base BS (récepteur, au sens des revendications), à l'aide d'un relais R. Les terminaux émettent des mots de code d'un code BCH (64, 51, 6) et le relais R effectue une combinaison linéaire des quatre mots de code C1 à C4 reçus, et émet un cinquième mot de code C'5, de la même façon qu'indiquée ci-dessus.

La station de base effectue un décodage itératif du code produit correspondant (BCH(64, 51, 6) * parité(5, 4, 2)), qui présente une distance minimum de 12.

Le rapport signal à bruit SNRi est défini comme l'énergie par bit reçu (donnée ou parité) divisé par le spectre de puissance du bruit de bande latérale unique. SNR1 correspond à la liaison entre un terminal et la station de base, SNR2 correspond à la liaison entre un terminal et le relais, et SNR3 correspond à la liaison entre le relais et la station de base. Pour les simulations de la figure 6A, on a fixé :

$$SNR2 = SNR1 + 3\ dB$$

$$SNR3 = SNR1,$$

ce qui est réaliste, du fait que le relais est placé entre les terminaux et les stations de base.

La figure 6A illustre le BER (taux d'erreur binaire - indice B) et le FER (taux d'erreur de trame - indice F) par rapport à SNR1. Trois situations sont illustrées correspondant respectivement à :

- un décodage sans relais, la station de base traitant uniquement les quatre mots de code BCH transmis par les terminaux : courbes 61 B, 61F ;
- un décodage à décision dure sur les valeurs LLR dans le relais : courbes 62B, 62F ;
- un décodage à décision souple sur les valeurs LLR dans le relais : courbes 63B, 63F.

Bien sûr, les meilleurs résultats sont obtenus avec cette dernière approche. On obtient alors des performances similaires à celle d'un décodage de type turbo décodage en blocs 64B, 64F d'un code produit BCH(64, 51, 6) * parité (5, 4, 2) dans lequel chaque terminal mettrait en oeuvre un code produit, ce qui introduirait un délai de codage important, non compatible avec des applications temps réel.

L'invention permet donc d'obtenir un décodage efficace, similaire à celui obtenu avec un turbo code, sans nécessiter la mise en oeuvre d'un tel turbo code dans les terminaux.

Il est par ailleurs possible de simplifier le traitement dans le relais, en utilisant simplement des décisions dures. La perte en performance reste faible, de l'ordre de 0,5 dB pour un taux d'erreur binaire BER de $10^{-5}$.

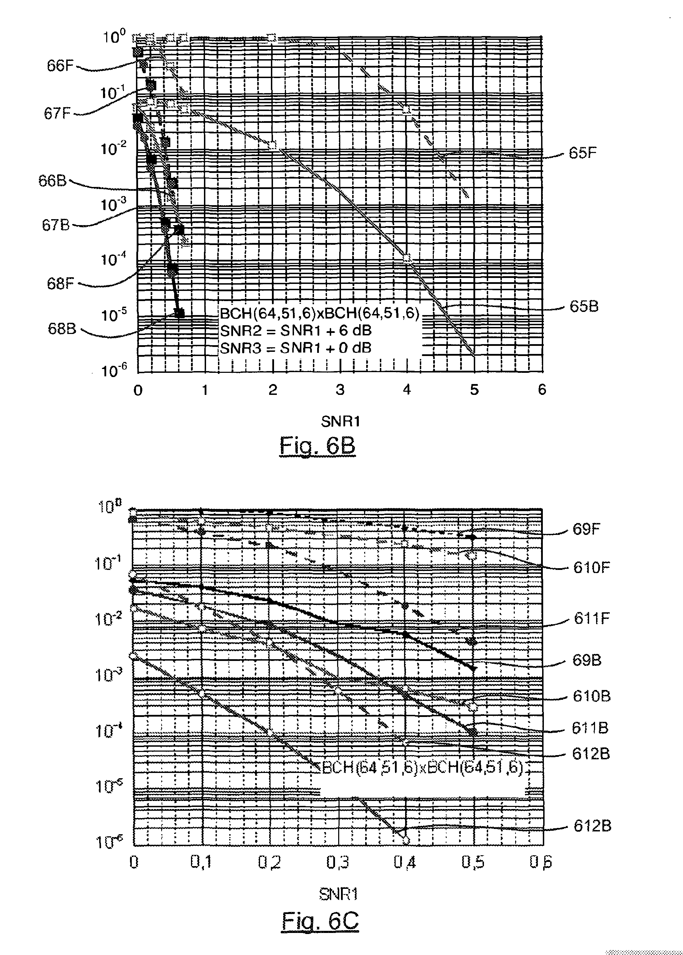

La figure 6B présente les performances lorsque le code utilisé par les terminaux et le relais est un code BCH (64, 51, 6), dans le cas où :

$$SNR2 = SNR1 + 6\ dB$$

$$SNR3 = SNR1.$$

Les courbes présentent respectivement :

- un décodage sans relais : 65B, 65F ;
- relais avec décisions dures : 66B, 66F ;
- relais avec décisions souples : 67B, 67F ;
- turbo décodage, pour comparaison : 68B, 68F.

On peut noter que l'on obtient un gain de plus de 4 dB pour un taux d'erreur binaire BER de $10^{-5}$, et que l'écart entre le décodage dur et le décodage souple dans le relais est faible, de l'ordre de 0,2 dB. Ceci est dû au fait que le relais introduit très peu d'erreurs.

La figure 6C illustre le taux d'erreur par rapport à SNR1 selon différentes valeurs de SNR2 et SNR3, dans le cas de décisions dures. On constate que l'augmentation de SNR2 augmente les performances dans le récepteur, puisque les erreurs introduites par le relais sont moindre. Tous les émetteurs profitent du rapport signal à bruit SNR3 dû à l'invention.

Les courbes présentent respectivement :

- 69B, 69F : SNR2 = SNR1 + 6 dB, SNR3 = SNR1 ;

- 610B, 610F : SNR2 = SNR1 + 6 dB, SNR3 = SNR1 + 3 dB ;
- 611B, 611F : SNR2 = SNR1 + 8 dB, SNR3 = SNR1 ;
- 612B, 612F : SNR2 = SNR1 + 8 dB, SNR3 = SNR1 + 3 dB.

On comprend qu'il est en conséquence possible, pour la station de base, d'adapter la puissance du relais pour contrôler le taux d'erreur dans la station de base.

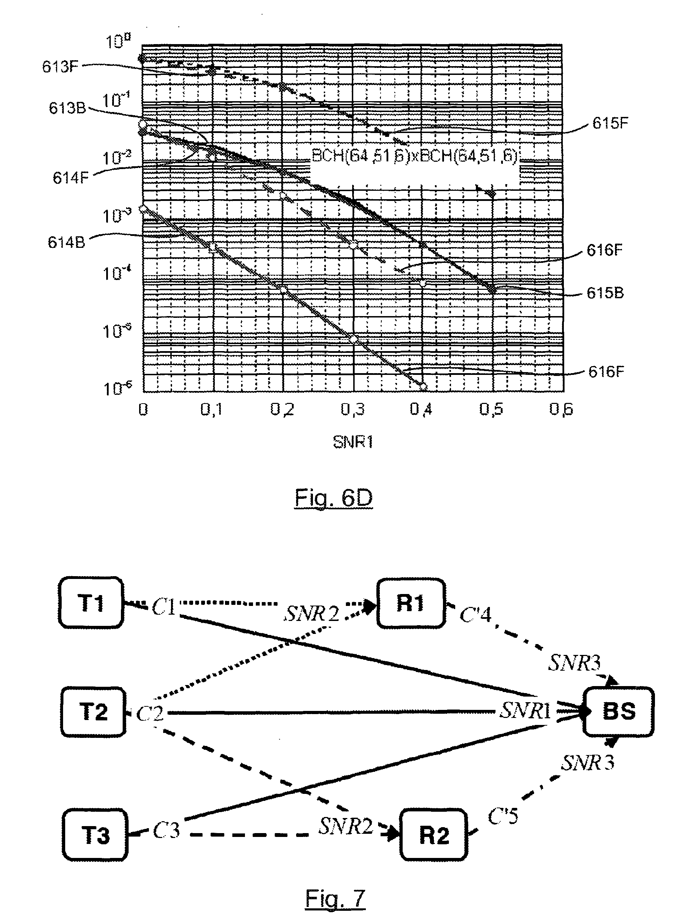

On note, sur la figure 6D, que la variation du gain est similaire dans le cas de décisions souples dans le relais. Cependant, les performances dans la station de base apparaissent indépendantes de SNR2, du fait qu'il n'y a pas d'erreur dans le relais dès que SNR2 est supérieur à 6 dB.

Les courbes présentent respectivement :

- 613B, 613F : SNR2 = SNR1 + 6 dB, SNR3 = SNR1 ;
- 614B, 614F : SNR2 = SNR1 + 6 dB, SNR3 = SNR1 + 3 dB ;
- 615B, 615F : SNR2 = SNR1 + 8 dB, SNR3 = SNR1 ;
- 616B, 616F : SNR2 = SNR1 + 8 dB, SNR3 = SNR1 + 3 dB.

*6.4 codage à correction d'erreur distribué*

On peut bien sûr généraliser l'approche décrite ci-dessus, pour former ce que l'on peut appeler un codage à correction d'erreur distribué, ou un codage turbo en réseau (« turbo network coding » en anglais).

Chaque terminal, ou émetteur plus généralement, peut transmettre des mots de code, par exemple de type BCH(n, k, $\delta$), dans chaque intervalle de temps, dans le cas d'une répartition AMRT.

Le nombre de terminaux peut le cas échéant varier dans le temps, de même que le nombre de mots de code émis par les différents terminaux, qui peut être différents selon les terminaux. Dans une trame donnée, formée de n intervalles de temps, les terminaux utilisent k intervalles et émettent donc k mots de code.

Le relais R reçoit et estime ces k mots de code, et place les estimations dans une matrice k*n. Il code ensuite les colonnes de cette matrice, avec un second code BCH(n, k, $\delta$), et transmet les n-k mots de code de redondance ainsi formés.

La station de base, ou plus généralement le récepteur, reçoit les k mots de code, avec un rapport signal à bruit SNR1 et les n-k mots de code de redondance avec un rapport signal à bruit SNR3.

*6.5 exemple de mise en oeuvre de plusieurs relais*

L'invention s'applique bien sûr au cas où l'on met en oeuvre plusieurs relais, comme illustré par la figure 7. Dans ce mode de réalisation, on prévoit trois terminaux T1, T2 et T3 et deux relais R1 et R2, émettant vers une station de base (récepteur).

Chaque terminal émet un mot de code Ci (i = 1 à 3). Le relais R1 reçoit C1 et C2, et le relais R2 reçoit C2 et C3. Les relais mettent en oeuvre des décisions dures, et délivrent respectivement C'4 et C'5.

La station de base BS reçoit donc C1, C2, C3, C'4 et C'5, et effectue un décodage itératif du code produit formé par les mots de code BCH (n, k, $\delta$) selon les lignes et les codes en bloc (5,3) définis par les équations de parité :

$$C4 = C1 \oplus C2$$

$$C5 = C2 \oplus C3$$

Ce code a une distance minimum de 2 et est constitué de 8 mots de code. Le décodage à entrées souples et sorties souples est donc très facile à implémenter.

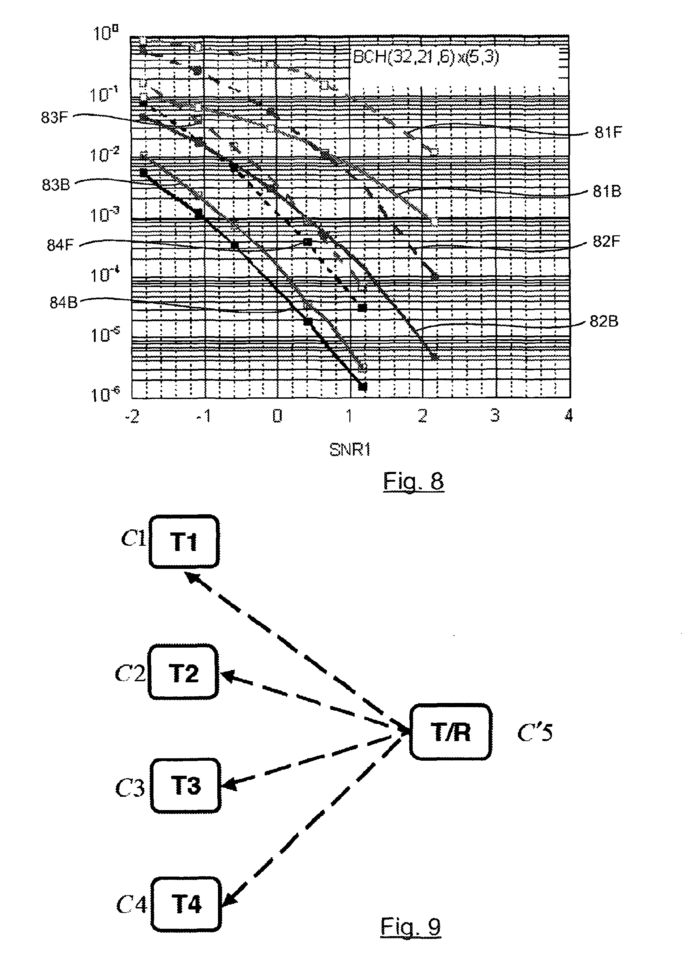

La figure 8 illustre le taux d'erreur en fonction du rapport signal à bruit SNR2, dans le cas de mots de code transmis par les terminaux BCH(32, 21, 6), dans le cas où SNR3 = SNR1.

Les courbes présentent respectivement :

- un décodage sans relais : 81B, 81F ;
- un décodage selon l'invention avec SNR2 = SNR1 + 3 dB et SNR3 = SNR1 : 82B, 82F ;
- un décodage selon l'invention avec SNR2 = SNR1 + 6 dB et SNR3 = SNR1 : 83B, 83F ;

- turbo décodage, pour comparaison : 84B, 84F.

Dans le cas où SNR2 = SNR1 + 6 dB, les performances sont similaires à un turbo décodage.

*6.6 réseaux locaux « ad hoc »*

L'invention peut également être mis en oeuvre par exemple dans des réseaux locaux ad-hoc, tel qu'illustré en figure 9. Il peut par exemple s'agir d'un réseau d'urgence, pour lequel on souhaite améliorer l'efficacité et limiter les délais de transmission.

Les terminaux T1 à T4 et T/R sont distribués dans une zone délimitée. Un des terminaux T/R est choisi comme relais (il peut également s'agir d'un relais dédié). Chaque terminal T1 à T4 émet un mot de code C1 à C4, que le relais T/R décode et traite pour émettre le mot de code C'5, qui est une combinaison linéaire des quatre mots de code C1 à C4. Chaque terminal démodule tous les mots de code, à l'exception de celui qu'il a lui-même émis, et réalise un turbo décodage de la matrice formée par les cinq mots de code.

*6.7 utilisation de deux seuils*

Au lieu d'utiliser un seuil unique dans le relais, on peut utiliser deux seuils +S et -S dans le relais. Dans ce cas, il est possible d'améliorer le traitement, en considérant que la valeur de LLR n'est pas prise en compte si elle est inférieure à S en valeur absolue. Si elle est supérieure, on effectue une décision dure.

Selon une première approche, on peut prévoir que le relais transmet, via un canal de signalisation, des informations identifiant les bits des mots de code qui ne sont pas significatifs. Si un bit participant à une équation de parité est associée à une fiabilité inférieure à S alors ce bit de parité est déclaré non-fiable.

Selon une deuxième approche, le relais transmet les données à l'aide de trois états {-1, 0, 1}. Cette dernière approche présente l'avantage de ne pas nécessiter de bande passante supplémentaire, ni de signalisation particulière, et de réduire l'énergie moyenne par bit d'information. En revanche, elle suppose des adaptations mineures dans les émetteurs et les récepteurs pour prendre en compte ces trois états.

*6.8 généralisation et variantes*

L'invention présente une rupture très importante par rapport à l'état de l'art. Elle permet grâce à l'introduction d'une opération de codage dans un relais de faire bénéficier à l'ensemble des émetteurs dispersés du gain de codage d'un turbo code. Elle ouvre de nombreuses perspectives :

- on peut utiliser différents types de codes dans les émetteurs du moment qu'ils sont linéaires (convolutif, BCH, RS, turbo codes, LDPC,..) ;
- au niveau du relais on peut remplacer le code de parité utilisé pour coder les colonnes par un code linéaire quelconque (convolutif, BCH, RS, turbo codes, LDPC, ...) ;
- au niveau du relais on peut envisager trois options, encodage sans ou avec correction d'erreurs en réception ou encore encodage sans correction au niveau du relais avec transmission d'un bit de signalisation pour indiquer la position des bits de parité de faible fiabilité ;
- on peut envisager plusieurs couches de codage.

Bien que les modes de réalisation décrits s'appuient sur un entrelacement lignes / colonnes, d'autres types d'entrelacement (par exemple du type utilisé pour le turbo codage) peuvent être utilisé dans les terminaux.

Les relais peuvent transmettre tout ou partie des informations de redondance (et par exemple uniquement la redondance associée aux colonnes de bits d'information).

L'invention peut bien sûr être généralisée à des codes produits à trois dimensions ou plus.

**Revendications**

1. Procédé de transmission d'un signal numérique entre au moins deux émetteurs ($T_1$,$T_2$) et au moins un récepteur (Bs), mettant en oeuvre une concaténation d'au moins deux codes,
le procédé comprenant :

- une première étape de codage, dans lesdits émetteurs chacun ($T_1$,$T_2$), délivrant au moins un premier mot de code ;

- une première étape d'émission desdits premiers mots de code ;
- une étape de réception, dans au moins un dispositif relais (R), d'au moins deux desdits premiers mots de code, appelés mots de code intermédiaires ;
- une étape d'entrelacement d'au moins une partie des bits desdits mots de code intermédiaires délivrant des bits entrelacés ;
- une seconde étape de codage desdits bits entrelacés, dans le ou lesdits relais, délivrant au moins un second mot de code tenant compte desdits mots de code intermédiaires ;
- une seconde étape d'émission du ou desdits seconds mots de code par le ou lesdits dispositifs relais,

de façon à permettre, dans le ou lesdits récepteurs, un décodage itératif tenant compte desdits premiers mots de code puis d'une redondance formée par le ou lesdits seconds mots de code.

2. Procédé selon la revendication 1, **caractérisé en ce que** ladite étape d'entrelacement met en oeuvre un entrelacement pseudo-aléatoire.

3. Procédé selon la revendication 1, **caractérisé en ce que** ladite étape d'entrelacement met en oeuvre une matrice lignes/colonnes d'un code produit.

4. Procédé selon la revendication 3, **caractérisé en ce que** lesdits premiers mots de code comprennent des bits d'information et des bits de redondance de ligne et lesdits seconds mots de code forment des mots de code de redondance à partir de bits de redondance de colonne, permettant la construction d'une matrice de code produit dans le ou lesdits récepteurs.

5. Procédé selon l'une quelconque des revendications 1 à 4, **caractérisé en ce que** lesdites première et seconde étapes d'émission mettent en oeuvre une technique d'accès multiple suivant une répartition en temps, TDMA, en fréquence, FDMA, et/ou par codes de modulation, CDMA.

6. Procédé selon l'une quelconque des revendications 1 à 5, **caractérisé en ce que** ladite étape de réception dans un desdits dispositifs relais met en oeuvre une décision dure sur la valeur de chacun des bits reçus dans ledit dispositif relais pour former lesdits mots de code intermédiaires.

7. Procédé selon l'une quelconque des revendications 1 à 5, **caractérisé en ce que** ladite étape de réception dans un desdits dispositifs relais met en oeuvre une sous-étape de seuillage sur la valeur de chacun des bits reçus dans ledit dispositif relais, délivrant des données seuillées, et une sous-étape de correction d'erreurs desdites données seuillées, pour former lesdits mots de code intermédiaires.

8. Procédé selon l'une quelconque des revendications 1 à 5, **caractérisé en ce que** ladite étape de réception dans un desdits dispositifs relais est suivie d'une étape de décodage souple sur la valeur souple de chacun des bits reçus dans ledit dispositif relais, pour former lesdits mots de code intermédiaires.

9. Procédé selon la revendication 8, **caractérisé en ce que** ladite étape de décodage souple met en oeuvre une étape de recherche d'un mot de code qui minimise l'erreur quadratique par rapport aux valeurs souples reçues.

10. Procédé selon l'une quelconque des revendications 1 à 9, **caractérisé en ce qu'**il comprend une étape d'affectation dans un dispositif relais, à au moins un bit desdits seconds mots de code, d'une information de fiabilité.

11. Procédé selon la revendication 10, **caractérisé en ce que** ladite information de fiabilité comprend au moins un bit de signalisation indiquant la position d'au moins un bit de faible fiabilité dans ledit second mot de code.

12. Procédé selon l'une quelconque des revendications 1 à 11, **caractérisé en ce que** ladite première étape de codage et/ou ladite seconde étape de codage met en oeuvre un codage linéaire appartenant au groupe comprenant :

- les codes convolutifs ;
- les codes BCH ;
- les codes RS ;
- les turbo-codes ;
- les codes LDPC binaires ou non-binaires ;
- les codes de parité.

**13.** Procédé selon l'une quelconque des revendications 1 à 12, **caractérisé en ce qu'**au moins un premier dispositif relais reçoit au moins un mot de code intermédiaire émis par un second dispositif relais.

**14.** Produit programme d'ordinateur téléchargeable depuis un réseau de communication et/ou enregistré sur un support lisible par ordinateur et/ou exécutable par un processeur, **caractérisé en ce qu'**il comprend des instructions de code de programme pour la mise en oeuvre du procédé de transmission selon l'une au moins des revendications 1 à 12.

**15.** Dispositif relais (R) pour la mise en oeuvre du procédé de transmission selon l'une quelconque des revendications 1 à 12, le dispositif relais comprenant :

- des moyens de réception d'au moins deux mots de code intermédiaires émis par au moins deux dispositifs émetteurs ($T_1$,$T_2$) et/ou au moins un autre dispositif relais ;
- des moyens d'entrelacement d'au moins une partie des bits desdits mots de code intermédiaires délivrant des bits entrelacés ;
- des moyens de codage desdits bits entrelacés, de façon à former au moins un second mot de code tenant compte desdits mots de code intermédiaires ;
- des moyens d'émission du ou desdits seconds mots de code.

**Patentansprüche**

**1.** Verfahren zum Übertragen eines Digitalsignals zwischen mindestens zwei Sendern ($T_1$, $T_2$) und mindestens einem Empfänger (Bs) unter Einsatz einer Verknüpfung von mindestens zwei Codes,
wobei das Verfahren Folgendes umfasst:

- einen ersten Codierungsschritt in den Sendern, wobei jeder ($T_1$, $T_2$) jeweils mindestens ein erstes Codewort liefert;
- einen ersten Schritt des Sendens der ersten Codewörter;
- einen Schritt des Empfangs mindestens zweier der ersten Codewörter, die Zwischencodewörter genannt werden, in mindestens einer Relaisvorrichtung (R);
- einen Schritt des Verknüpfens mindestens eines Teils der Bits der Zwischencodewörter, der verknüpfte Bits liefert;
- einen zweiten Codierungsschritt der verknüpften Bits in dem oder den Relais, der mindestens ein zweites Codewort liefert, das die Zwischencodewörter berücksichtigt;
- einen zweiten Schritt des Sendes des oder der zweiten Codewörter durch die Relaisvorrichtung(en),

um in dem oder den Empfängern eine iterative Decodierung zu ermöglichen, die die ersten Codewörter und dann eine von dem oder den zweiten Codewörtern gebildete Redundanz berücksichtigt.

**2.** Verfahren nach Anspruch 1, **dadurch gekennzeichnet, dass** der Verknüpfungsschritt eine pseudo-zufällige Verknüpfung einsetzt.

**3.** Verfahren nach Anspruch 1, **dadurch gekennzeichnet, dass** der Verknüpfungsschritt eine Zeilen/Spalten-Matrix eines erzeugten Codes einsetzt.

**4.** Verfahren nach Anspruch 3, **dadurch gekennzeichnet, dass** die ersten Codewörter Informationsbits und Zeilenredundanzbist umfassen, und die zweiten Codewörter Redundanzcodewörter aus Spaltenredundanzbits bilden, die den Aufbau einer Matrix des in dem oder den Empfängern erzeugten Codes ermöglichen.

**5.** Verfahren nach einem der Ansprüche 1 bis 4, **dadurch gekennzeichnet, dass** der erste und der zweite Sendeschritt eine multiple Zugriffstechnik nach einer Zeitverteilung TDMA, einer Frequenzverteilung FDMA und/oder durch Modulationscodes CDMA einsetzen.

**6.** Verfahren nach einem der Ansprüche 1 bis 5, **dadurch gekennzeichnet, dass** der Empfangsschritt in einer der Relaisvorrichtungen eine feste Entscheidung über den Wert jedes der in der Relaisvorrichtung empfangenen Bits einsetzt, um die Zwischencodewörter zu bilden.

**7.** Verfahren nach einem der Ansprüche 1 bis 5, **dadurch gekennzeichnet, dass** der Empfangsschritt in einer der Relaisvorrichtungen einen Unterschritt des Prüfens des Werts jedes der in der Relaisvorrichtung empfangenen Bits, der geprüfte Daten liefert, und einen Unterschritt der Fehlerkorrektur der geprüften Daten einsetzt, um die Zwischencodewörter zu bilden.

**8.** Verfahren nach einem der Ansprüche 1 bis 5, **dadurch gekennzeichnet, dass** auf den Empfangsschritt in einer der Relaisvorrichtungen ein flexibler Decodierungsschritt zu dem flexiblen Wert jedes der in der Relaisvorrichtung empfangenen Bits folgt, um die Zwischencodewörter zu bilden.

**9.** Verfahren nach Anspruch 8, **dadurch gekennzeichnet, dass** der flexible Decodierungsschritt einen Schritt der Suche nach einem Codewort einsetzt, der den Quadratfehler in Bezug auf die empfangenen flexiblen Werte minimiert.

**10.** Verfahren nach einem der Ansprüche 1 bis 9, **dadurch gekennzeichnet, dass** es einen Schritt der Zuweisung der zweiten Codewörter, einer Zuverlässigkeitsinformation an mindestens ein Bit in einer Relaisvorrichtung umfasst.

**11.** Verfahren nach Anspruch 10, **dadurch gekennzeichnet, dass** die Zuverlässigkeitsinformation mindestens ein Anzeigebit umfasst, das die Position mindestens eines Bits von geringer Zuverlässigkeit in dem zweiten Codewort anzeigt.

**12.** Verfahren nach einem der Ansprüche 1 bis 11, **dadurch gekennzeichnet, dass** der erste Codierungsschritt und/ oder der zweite Codierungsschritt eine lineare Codierung einsetzt, die der Gruppe angehört, die Folgendes umfasst:

- die konvolutiven Codes;
- die Codes BCH;
- die Codes RS;
- die Turbocodes;
- die binären oder nicht binären Codes LPDC;
- die Paritätscodes.

**13.** Verfahren nach einem der Ansprüche 1 bis 12, **dadurch gekennzeichnet, dass** mindestens eine erste Relaisvorrichtung mindestens ein Zwischencodewort empfängt, das von einer zweiten Relaisvorrichtung entsandt wird.

**14.** Computerprogrammprodukt, das von einem Kommunikationsnetz fernladbar ist und/oder auf einem vom Computer lesbaren Träger gespeichert ist und/oder von einem Prozessor ausführbar ist, **dadurch gekennzeichnet, dass** es Programmcodebefehle für den Einsatz des Übertragungsverfahrens nach mindestens einem der Ansprüche 1 bis 12 umfasst.

**15.** Relaisvorrichtung (R) für den Einsatz des Übertragungsverfahrens nach einem der Ansprüche 1 bis 12, wobei die Relaisvorrichtung Folgendes umfasst:

- Mittel für den Empfang mindestens zweier Zwischencodewörter, die von mindestens zwei Sendern ($T_1$, $T_2$) und/oder mindestens einer weiteren Relaisvorrichtung entsandt werden;
- Mittel zum Verknüpfen mindestens eines Teils der Bits der Zwischencodewörter, die verknüpfte Bits liefern;
- Mittel zum Codieren der verknüpften Bits, um mindestens ein zweites Codewort zu bilden, das die Zwischencodewörter berücksichtigt;
- Mittel zum Senden des oder der zweiten Codewörter.

## Claims

**1.** Method for transmitting a digital signal between at least two transmitters ($T_1$, $T_2$) and at least one receiver (BS), using a concatenation of at least two codes,
**characterized in that** the method comprises:

- a first coding step in said transmitters, each transmitter ($T_1$, $T_2$) delivering at least a first code word;
- a first transmission step, in which said first code words are transmitted;
- a receiving step in which at least two of said first code words, called intermediate code words, are received in at least one relay device (R);

- an interleaving step performed on at least some of the bits of said intermediate code words, delivering interleaved bits;

- a second coding step performed on said interleaved bits, in said relay or relays, delivering at least a second code word, taking said intermediate code words into account; and

- a second transmission step in which said second code word or words are transmitted by said relay device or devices,

in such a way that iterative decoding can take place in said receiver or receivers, taking into account said first code words followed by a redundancy formed by said second code word or words.

2. Method according to Claim 1, **characterized in that** said interleaving step uses pseudorandom interleaving.

3. Method according to Claim 1, **characterized in that** said interleaving step uses a row/column matrix of a product code.

4. Method according to Claim 3, **characterized in that** said first code words comprise row data and redundancy bits, and said second code words form redundancy code words from column redundancy bits, enabling a product code matrix to be constructed in said receiver or receivers.

5. Method according to any one of Claims 1 to 4, **characterized in that** said first and second transmission steps use a time division multiple access (TDMA) method, a frequency division multiple access (FDMA) method, and/or a code division multiple access (CDMA) method.

6. Method according to any one of Claims 1 to 5, **characterized in that** said step of reception in one of said relay devices uses a hard decision on the value of each of the bits received in said relay device for forming said intermediate code words.

7. Method according to any one of Claims 1 to 5, **characterized in that** said step of reception in one of said relay devices uses a sub-step of thresholding on the value of each of the bits received in said relay device, delivering thresholded data, and a sub-step of correction of errors in said thresholded data, to form said intermediate code words.

8. Method according to any one of Claims 1 to 5, **characterized in that** said receiving step in one of said relay devices is followed by a soft decoding step performed on the soft value of each of the bits received in said relay device, for forming said intermediate code words.

9. Method according to Claim 8, **characterized in that** said soft decoding step uses a step of searching for a code word which minimizes the squared error with respect to the soft values received.

10. Method according to any one of Claims 1 to 9, **characterized in that** it comprises a step, performed in a relay device, of assigning a reliability data element to at least one bit of said second code words.

11. Method according to Claim 10, **characterized in that** said reliability data element comprises at least one signalling bit indicating the position of at least one bit of low reliability in said second code word.

12. Method according to any one of Claims 1 to 11, **characterized in that** said first coding step and/or said second coding step uses a linear coding belonging to the group comprising:

- convolution codes;
- BCH codes;
- RS codes;
- turbo codes;
- binary or non-binary LDPC codes; and
- parity codes.

13. Method according to any one of Claims 1 to 12, **characterized in that** at least a first relay device receives at least one intermediate code word sent by a second relay device.

14. Computer program product which can be downloaded from a communication network and/or stored on a computer-readable medium and/or executed by a processor, **characterized in that** it comprises program code instructions for the use of the transmission method according to at least one of Claims 1 to 12.

15. Relay device (R) for the use of the transmission method according to any one of Claims 1 to 12, **characterized in that** the relay device comprises :

   - means for receiving at least two intermediate code words sent by at least two transmitter devices ($T_1$, $T_2$) and/or at least one other relay device;
   - means for interleaving at least some of the bits of said intermediate code words, delivering interleaved bits;
   - means for coding said interleaved bits, so as to form at least a second code word, taking said intermediate code words into account;
   - means for transmitting said second code word or words.

Fig. 1

Fig. 2

Fig. 3

Fig. 4

Fig. 5

BCH(64,51,6)x(5,4,2)
SNR2 = SNR1 + 3 dB
SNR3 = SNR1

SNR1 (dB)

Fig. 6A

BCH(64,51,6)xBCH(64,51,6)
SNR2 = SNR1 + 6 dB
SNR3 = SNR1 + 0 dB

SNR1

Fig. 6B

BCH(64,51,6)xBCH(64,51,6)

SNR1

Fig. 6C

Fig. 6D

Fig. 7

Fig. 8

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. YANG ; R. KOETTER.** Network Coding over a Noisy Relay: a Belief Propagation Approach. *Proc. IEEE ISIT '07, Nice, France,* Juin 2007
- Joint Design of Network Coding and Channel Decoding for Wireless Networks. *Proc. IEEE WCNC '07,* 11 Mars 2007, 779-784
- **M. VALENTI ; B. ZHAO.** Distributed turbo codes: towards the capacity of the relay channel. *VTC IEEE,* Octobre 2003
- **C. BERROU ; A. GLAVIEUX.** Near Shannon limit error-correcting coding and decoding : Turbo-codes (1. *IEEE Int. Conf. on Comm. ICC' 93,* Mai 1993, vol. 2/3, 1064-1071
- **P. ELIAS.** Error-free coding. *IRE Trans. on Inf. Theory,* Septembre 1954, vol. IT-4, 29-37
- Near optimum decoding of product codes : block turbo codes. *IEEE, Trans. on Communications,* Août 1998, vol. 46 (8